# EUROPÄISCHE PATENTSCHRIFT

(11) **EP 2 018 684 B1**
(45) Veröffentlichungstag und Bekanntmachung des Hinweises auf die Patenterteilung: **09.09.2009**
(21) Anmeldenummer: 07724777.3
(22) Anmeldetag: 02.05.2007
(51) Int. Cl.: H01R 13/502, H01R 12/08

(54) **MODUL MIT ANSCHLÜSSEN FÜR AKTOREN UND/ODER SENSOREN**
MODULE WITH CONNECTORS FOR ACTUATORS AND/OR SENSORS
MODULE AVEC DES RACCORDS POUR ACTIONNEURS ET/OU CAPTEURS

(30) Priorität: 17.05.2006 DE 102006023351
(43) Veröffentlichungstag der Anmeldung: 28.01.2009
(73) Patentinhaber: Phoenix Contact GmbH & Co. KG, 32825 Blomberg (DE)
(72) Erfinder: BEIER, Thomas, 33758 Schloß Holte-Stukenbrock (DE); BEHLING, Bernd, 32839 Steinheim (DE)
(86) Internationale Anmeldenummer: PCT/EP2007/003851
(87) Internationale Veröffentlichungsnummer: WO 2007/131631

(56) Entgegenhaltungen:
- DE-C2- 19 630 352
- DE-U1- 29 919 900
- US-A- 5 321 592

## Beschreibung

Die Erfindung betrifft ein Modul mit Anschlüssen für Aktoren und/oder Sensoren gemäß dem Oberbegriff des Anspruchs 1.

Aus der DE 196 30 352 C2 ist bereits ein derartiges Modul bekannt. Das bekannte Modul besteht aus einem Unterteil und einem Gehäuseoberteil mit einer im Innenraum angeordneten Leiterplatte. Das Gehäuseoberteil ist im Wesentlichen quaderförmig ausgebildet und weist eine Oberseite, Unterseite und umfangsseitig zwei Längsseiten sowie zwei Stirnseiten auf. Auf der Oberseite sind Anschlüsse für Aktoren und/oder Sensoren angeordnet. Sie sind als Steck- und/oder Schraubanschlüsse ausgebildet und mit der in dem Gehäuseoberteil gelagerten Leiterplatte verbunden. An der Leiterplatte sind Kontaktierungsstifte einer Kontaktierungseinrichtung angelötet. Sie ragen mit ihren Spitzen aus der Unterseite heraus.

Das Unterteil weist eine in den Abmessungen auf die Unterseite angepasste Oberseite mit Ausnehmungen zur Aufnahme zweier formcodierter Flachkabel auf, welche bspw. als Busleitungen oder Steuerleitungen ausgebildet sein können.

Zur genauen Führung des Gehäuseoberteils in eine Befestigungsausgangsposition, bei dem die Kontaktstifte mit ihren Spitzen genau auf die Leitungsadern von in dem Unterteil eingelegten Flachkabeln weisen, sind einerseits stirnseitig an dem Gehäuseoberteil und dem Unterteil Schwenkmittel sowie Positioniernasen mit entsprechenden Aufnahmen im Bereich der Aufnahmen für die Flachkabel vorgesehen. Aus der Befestigungsausgangsposition kann das Gehäuseoberteil mittig im Kontaktbereich über eine mit dem Unterteil verbunden und die Durchkontaktierung von in dem Unterteil eingelegten formcodierten Flachkabel mit den Kontaktstiften sichergestellt werden.

Ausgehend von diesem Stand der Technik liegt der Erfindung die Aufgabe zugrunde, ein Modul mit Anschlüssen für Aktoren und/oder Sensoren mit einer alternativen und einfachen Möglichkeit zur Führung des Gehäuseoberteils in seine Befestigungsausgangsposition anzugeben.

Die Erfindung löst die Aufgabe durch ein Modul mit Anschlüssen für Aktoren und/oder Sensoren mit den Merkmalen des Anspruchs 1. Dieses Modul weist mit den Längsseiten des Gehäuseoberteils zusammenwirkende Führungsmittel auf. Hierdurch wird der Vorteil erreicht, dass das Gehäuseoberteil besonders einfach auf das Unterteil und in die Befestigungsausgangsposition zur Befestigung der beiden Modulteile geführt werden kann. Zusätzlich wird der Vorteil erzielt, dass das Gehäuseoberteil bei dieser Art der Führung auf das Unterteil in Querrichtung des Modul ausgerichtet wird. Weitere vorteilhafte Ausgestaltungen der Erfindung sind in den Unteransprüchen angegeben.

Um Toleranzen des Gehäuseoberteils zu dem Unterteil in Querrichtung in der Befestigungsausgangsposition zu minimieren sieht eine vorteilhafte Weiterbildung der Erfindung vor, dass die Führungsmittel derart konfiguriert sind, dass sie zur umfangseitigen Klemmung des Gehäuseoberteils geeignet sind. Dies ist sehr einfach, wenn die Seitenwände des Unterteils als Führungsmittel für das Gehäuseoberteil fungieren. Eine genaue Ausrichtung des Gehäuseoberteils in Längsrichtung kann über an den Längsseiten oder Seitenwänden angebrachte Nuten und/oder Anschlagelemente erreicht werden.

Das Gehäuseoberteil weist neben seinen Längsseiten und Stirnseiten eine hieran angrenzende Oberseite mit den Anschlüssen für die Aktoren und/oder Sensoren und eine Unterseite auf. Bei bereits an den Anschlüssen angeschlossenen Aktoren und/oder Sensoren ist oftmals noch ein Wechseln der Flachkabel notwendig. Deshalb ist vorgesehen, dass das Gehäuseoberteil in eine Montageposition bewegt werden kann, bei der der Zugriff zu eingesetzten Flachkabeln gegeben ist. Nach dem bekannten Stand der Technik kann das Modul durch Aufschwenken des Gehäuseoberteils in die Montageposition geführt werden. Ein Aufschwenken von dem Unterteil ist jedoch oftmals aus Raumgründen ungünstig. Ist das Modul bspw. an einer Wand montiert, so wird der Aufschwenkwinkel durch die auf der Oberseite angeschlossenen Aktoren und/oder Sensoren mit ihren Kabeln begrenzt. Sie stoßen beim Aufschwenken gegen die Wand und können ggf. hierbei beschädigt werden.

Deshalb sieht eine vorteilhafte Weiterentwicklung vor, dass die Führungsmittel derart an dem Gehäuseoberteil und/oder dem Unterteil ausgebildet sind, dass das Gehäuseoberteil über eine Transversalbewegung aus der Befestigungsausgangsposition in die Montageposition führbar und rückführbar ist. Wird gemäß dieser Ausführung das Gehäuseoberteil von der Befestigungsausgangsposition über eine Transversalbewegung in die Montageposition geführt, so behindern die angeschlossenen Sensoren und/oder Aktoren diesen Vorgang nicht. Im einfachsten Fall kann die Transversalbewegung durch Verschieben des Gehäuseoberteils gegenüber dem Unterteil realisiert sein.

Zur gezielten Führung des Gehäuseoberteils in die Befestigungsausgangsposition, aus der das Gehäuseoberteil auf dem Unterteil befestigt werden kann, ist in einer erfindungsgemäßen Weiterentwicklung vorgesehen, dass als Führungsmittel auf den beiden Längsseiten des Gehäuseoberteils wenigstens jeweils eine Führungsnut und auf den beiden Seitenwänden des Unterteils jeweils wenigstens ein zu der gegenüberliegenden Seitenwand weisender Führungszapfen angeordnet sind. Das Gehäuseoberteil wirkt bei dieser Weiterentwicklung mit dem Unterteil in der Art zusammen, dass die Führungszapfen in die Führungsnuten eingreifen. Hierdurch ist das Gehäuseoberteil quer zum Verlauf der Führungsnuten gesichert. Dieser Vorteil besteht auch, wenn das Gehäuseoberteil von der Befestigungsausgangsposition in die Montageposition geführt wird, in der formcodierte Flachkabel in die in dem Boden des Unterteils vorgesehenen Ausnehmungen eingelegt oder bereits eingelegte durch andere ersetzt werden können.

Um das Gehäuseoberteil auch gegen eine Verschiebung in Richtung des Nutverlaufs zu sichern, sieht eine weiterführende Ausgestaltung der Erfindung vor, dass die Führungsnuten jeweils wenigstens eine Verrastungsposition zum Einrasten der in ihr geführten Führungszapfen aufweisen. Die Verrastungsposition kann bspw. durch eine zu dem Führungszapfen formschlüssige Vertiefung innerhalb der Führungsnuten ausgeführt sein. Durch die Verrastung kann das Gehäuseoberteil in der Montageposition unabhängig von räumlichen Ausrichtung des Moduls gehalten werden, so dass ein Monteur beidhändig bereits in das Unterteil eingelegte formcodierte Flachkabel ersetzen kann.

Eine weitere erfindungsgemäße Weiterentwicklung sieht vor, dass die Führungsnut zwei Verrastungspostionen aufweist. Hierdurch wird erreicht, dass das Gehäuseoberteil und das Unterteil unverlierbar miteinander verbunden sind, sobald die Führungszapfen in die Führungsnuten eingreifen. Hierbei ist es vorteilhaft, die Verrastungspositionen derart anzuordnen, dass sie das Gehäuseoberteil zu dem Unterteil in der Befestigungsausgangsposition und in der Montageposition fixieren.

Zweckmäßiger Weise ist auf den beiden Seitenwänden von dem Gehäuseoberteil jeweils eine zu der Führungsnut führende und von dem Rand der jeweiligen Seitenwand ausgehende Einführungsnut vorgesehen.

Damit eine stabile und kippsichere Führung des Gehäuseoberteils erreicht wird, sind auf den beiden Längsseiten des Gehäuseoberteils wenigstens jeweils zwei zueinander parallel angeordnete Führungsnuten vorgesehen, wobei auf den beiden Seitenwänden des Unterteils jeweils wenigstens zwei den Führungsnuten zugeordnete Führungszapfen ausgebildet sind. Alternativ hierzu ist es aber auch denkbar als Führungsmittel eine einzige Führungsnut und anstelle eines rund ausgebildeten Führungszapfens ein im Querschnitt längliches Führungselement vorzusehen.

Eine vorteilhafte Weiterentwicklung sieht vor, dass die beiden parallel zueinander angeordneten Führungsnuten durch eine Verbindungsnut miteinander verbunden sind. Durch die Verbindungsnut können Führungszapfen von einer in die andere Führungsnut geführt werden, wodurch die Lage des Gehäuseoberteils zu dem Unterteil verändert werden kann.

Um eine schnelle Befestigung des Moduls auf einer bspw. in einem Schaltschrank angeordneten Tragschiene zu ermöglichen, sieht eine besondere Ausgestaltung der Erfindung vor, dass in dem Boden des Unterteils ein ausgesparter Bereich vorgesehen ist, wobei über einen Abschnitt des hieran angrenzenden Randbereichs eine Tragschiene mit ihren Halteabschnitten aufnehmbar ist.

### Bezugszeichenliste

- Gehäuseoberteil: 1
- Unterteil: 2
- Modul: 3
- Oberseite: 4
- Längsseiten: 5
- Stirnseiten: 6
- Anschlüsse: 7
- formcodierte Flachkabel: 8
- Leiter: 8.1
- Seitenwände: 9
- Boden: 10
- Führungsmittel: 11, 12
- Führungszapfen: 11
- vorderer Führungszapfen: 11.1
- hinterer Führungszapfen: 11.2
- Führungsnuten: 12
- obere Führungsnut: 12.1
- untere Führungsnut: 12.2
- Befestigungsmittel: 13, 14
- Verriegelungshebel: 13
- Verriegelungszapfen: 14
- Griff: 15
- Führungsabschnitt: 16
- Kontaktbereich: 17
- Gehäuseoberteilende: 18
- Einführungsnut: 19
- vordere Führungszapfen: 19.1
- hintere Einführungsnut: 19.2
- Verbindungsnut: 21
- Verrastungsposition: 23
- ausgesparter Bereich: 27
- angrenzender Randbereich: 29
- Tragschiene: 31
- Halteabschnitte: 33
- Feder: 35
- Überfeder: 36
- Aufnahmeeinsatz: 37
- Ausnehmung: 38
- Durchbruch: 39
- erste Schmalseite: 40
- Haltenase: 41
- zweite Schmalseite: 42
- Federelement: 43
- Aufnahmebereich: 45
- Montagebohrung: 47
- Erdungskontakt: 49

Das erfindungsgemäße Modul ist nachfolgend in einem Ausführungsbeispiel beschrieben und zeichnerisch dargestellt. In der Zeichnung zeigen
- Fig. 1: in Perspektive ein erfindungsgemäßes Modul mit einem Gehäuseoberteil und einem Unterteil im geschlossenen Zustand,
- Fig. 2: das Modul aus Fig. 1 in Befestigungsausgangsposition,
- Fig. 3: das Modul aus Fig. 1 in Montageposition,
- Fig. 4: das Gehäuseoberteil des Moduls aus Fig. 1 mit auf seinen Längsseiten ausgebildeten Führungsnuten,
- Fig. 5: das Unterteil des Moduls aus Fig. 1 mit einem auf seinem Boden montiertem Aufnahmeeinsatz mit Ausnehmungen, in denen formcodierte Leiter eingelegt sind,
- Fig. 6: das Unterteil aus Fig. 5 in hierzu gedrehter Darstellung mit Sicht auf den Boden ohne Aufnahmeeinsatz,
- Fig. 7: einen Aufnahmeeinsatz mit Ausnehmungen zur Aufnahme formcodierter Flachkabel in perspektivischer Darstellung,
- Fig. 8a u. 8b: den Aufnahmeeinsatz aus Fig. 7 in Vorderansicht und
- Fig. 9: das Unterteil des Moduls aus Fig. 1 mit aufgenommener Tragschiene.

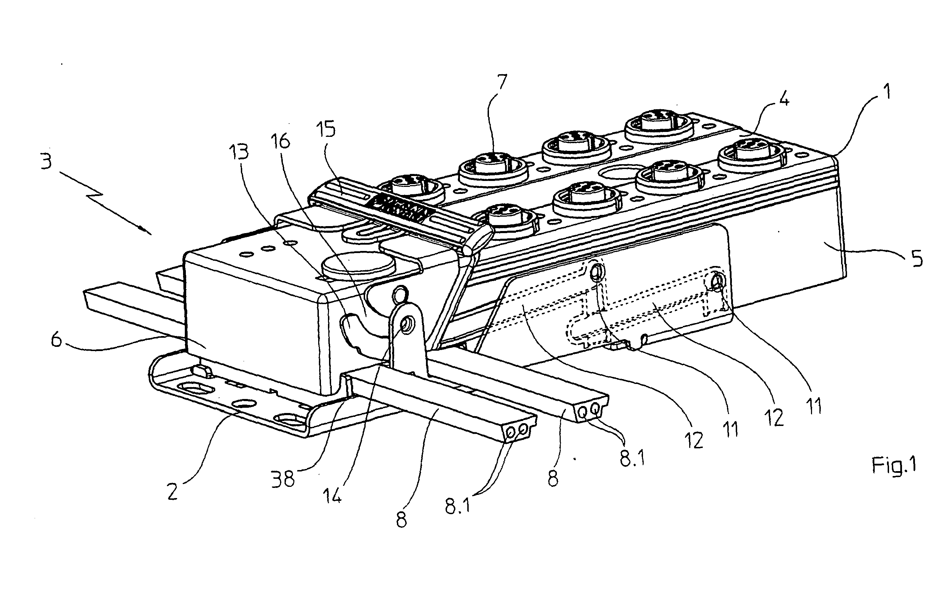

Fig. 1 zeigt ein aus einem Gehäuseoberteil 1 und einem Unterteil 2 zusammengesetztes Modul 3 im montierten und geschlossenen Zustand. Das Gehäuseoberteil 1 ist vorzugsweise quaderförmig ausgebildet und weist eine Oberseite 4, eine hierzu parallel angeordnete und nicht dargestellte Unterseite sowie umfangsseitig zwei Längsseiten 5 und zwei Stirnseiten 6 auf. Auf der Oberseite 4 sind Anschlüsse 7 für Stecker von Aktoren und/oder Sensoren angeordnet. Diese Anschlüsse 7 sind in an sich bekannter Weise über eine in dem Gehäuseoberteil 1 aufgenommene und nicht dargestellte Leiterplatte mit aus der Unterseite hervorstehenden Kontaktspitzen einer Kontakteinrichtung verbunden. In dem geschlossenen Zustand des Moduls 3 gemäß Fig. 1 durchdringen die Kontaktspitzen in das Unterteil 2 eingelegte formcodierte Flachkabel 8 zumindest teilweise und stellen hierdurch einen elektrischen Kontakt zwischen den Anschlüssen 7 und den Leitern 8.1 der formcodierten Flachkabel 8 sicher.

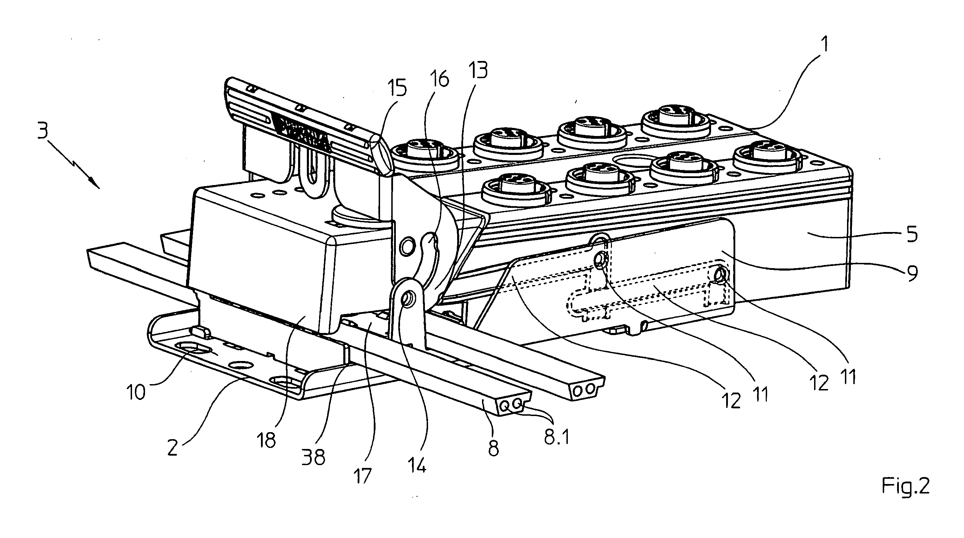

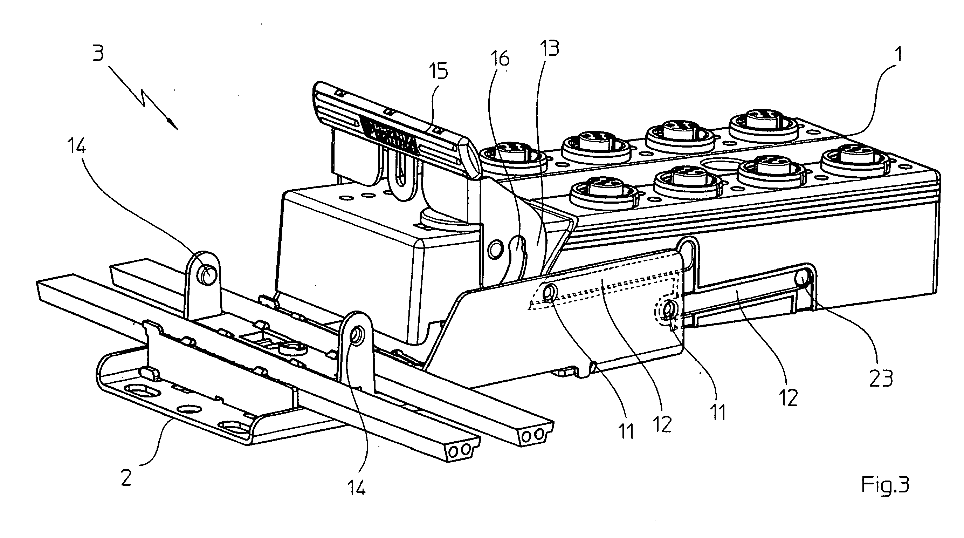

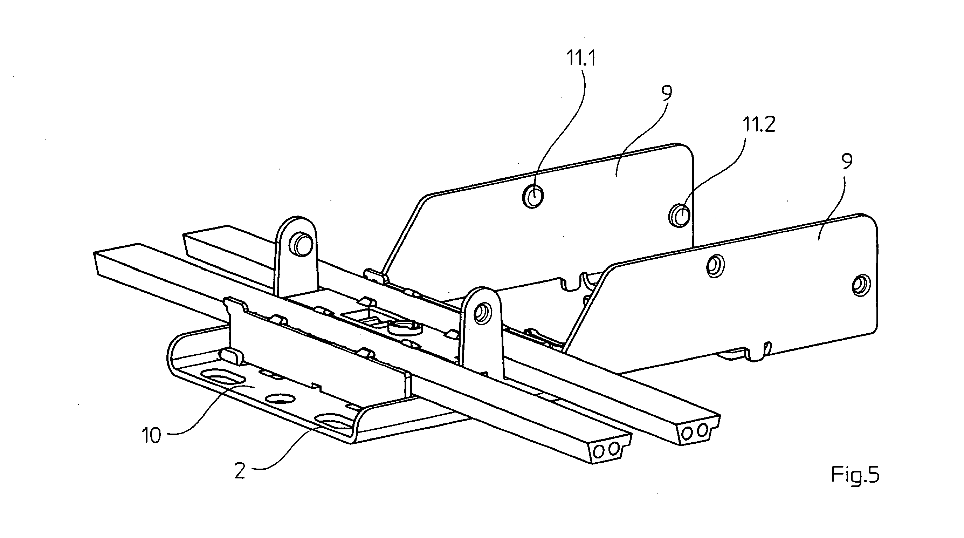

Die Längsseiten 5 des Gehäuseoberteils 1 sind als Führungsmittel 11, 12 ausgebildet, über die das Gehäuseoberteil 1 aus einer Montageposition nach Fig. 3 zum Wechseln der Flachkabel 8 in eine in Fig. 2 gezeigte Befestigungsausgangsposition führbar ist. Aus der Befestigungsausgangsposition nach Fig. 2 ist das Gehäuseoberteil 1 auf dem Unterteil 2 mit seinen auf diesen angeordneten Befestigungsmittel 13, 14 unmittelbar, also ohne einen Montagezwischenschritt, befestigbar. Dies wird durch Ausrichtung des Gehäuseoberteil 1 zu dem Unterteil 2 und der Befestigungsmittel 13, 14 zueinander erreicht. Zur Ausrichtung des Gehäuseoberteils 1 zu dem Unterteil 2 in Querrichtung weist das Unterteil 2 gem. Fig. 5 zwei Seitenwände 9 auf.

Der senkrechte Abstand der Seitenwände 9 zueinander ist vorzugsweise etwas kleiner gewählt als die Breite des Gehäuseoberteils 1, damit es klemmend aufgenommen wird und kein Spiel in Querrichtung vorliegt.

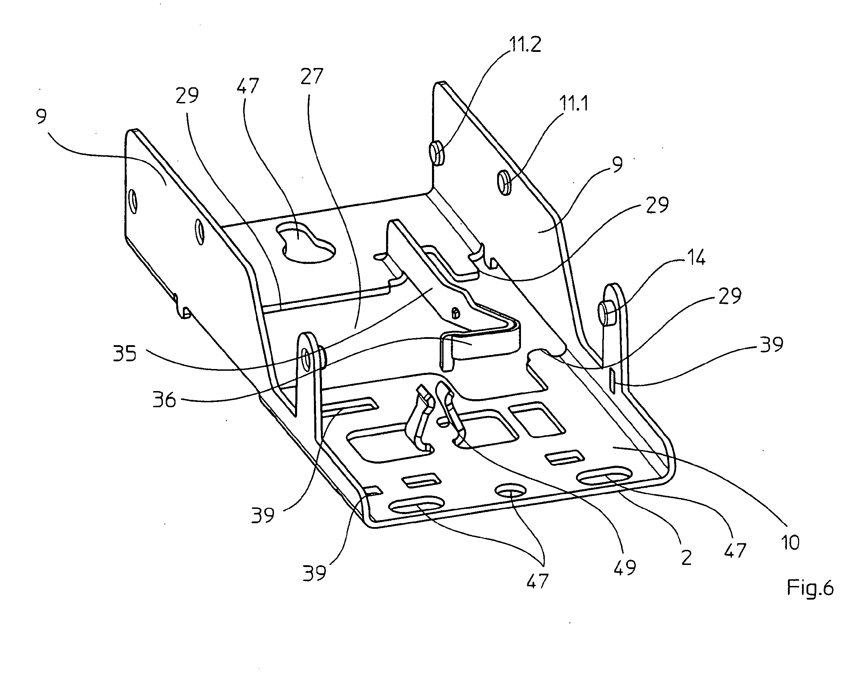

Wie aus Fig. 5 und 6 ersichtlich, ist das Unterteil 2 in Art einer stirnseitig offenen Aufnahmekammer mit Boden 10 gebildet, auf deren Seitenwänden 9 jeweils ein vordere Führungszapfen 11.1 und ein hintere Führungszapfen 11.2 vorgesehen sind. Die Führungszapfen 11.1, 11.2 weisen jeweils zu der gegenüberliegenden Seitenwand 9 und sind bezogen auf den Boden 10 unterschiedlich hoch angeordnet. Die Führungszapfen 11.1, 11.2 bilden einen ersten Teil der Führungsmittel 11, 12 zur gezielten Führung des Gehäuseoberteils 1 in die Befestigungsausgangsposition nach Fig. 2.

Als zweiter Teil der Führungsmittel 11, 12 sind Führungsnuten 12 auf den Längsseiten 5 des Gehäuseoberteils 1 vorgesehen. Die Breite der Führungsnuten 12 ist an den Durchmesser der Führungszapfen 11 angepasst. Im zusammengebauten Zustand des Moduls 3 gemäß Fig. 1 bis 3 greifen die Führungszapfen 11 in die Führungsnuten 12 ein. Durch das Zusammenwirken der Führungsnuten 12 und der Führungszapfen 11 lässt sich das Gehäuseoberteil 1 relativ zu dem Unterteil 2 über eine Transversalbewegung zwischen der in Fig. 2 gezeigten Befestigungsausgangsposition und der Montageposition gem. Fig. 3 verschieben.

Die Führungsnuten 12 verlaufen in Bezug auf die Oberseite 4 bzw. Unterseite des Gehäuseoberteils 1 schräg. Dementsprechend ist in der Befestigungsausgangsposition nach Fig. 2 das Gehäuseoberteil 1 zu dem Boden 10 des Unterteils 2 geneigt angeordnet, wobei der Abstand zwischen dem Boden 10 und dem Gehäuseoberteil 1 am Gehäuseoberteilende 18,das in dem Kontaktbereich angeordnet ist, maximal ist.

In dem Kontaktbereich 17 des Moduls 3 sind als Befestigungsmittel 13, 14 ein an den Längsseiten 5 gelagerter Verriegelungshebel 13 und an den Seitenwänden 9 angebrachte Verriegelungszapfen 14 angeordnet. Der Verriegelungshebel 13 weist einen Griff 15 und einen kurvenförmig ausgebildeten Führungsabschnitt 16 auf.

Zur Überführung des Moduls 3 aus seiner Befestigungsausgangsposition gem. Fig. 2 in seinen geschlossenen Zustand nach Fig. 1 wird der Verriegelungshebel 13 mit seinem Griff 15 in Richtung der Anschlüsse 7 bewegt. Zu Beginn dieser Bewegung umschließt zunächst der kurvenförmige Führungsabschnitt 16 die Verriegelungszapfen 14. Bei weitere Führung des Griffs 15 in Richtung der Anschlüsse 7 drückt der kurvenförmig ausgebildete Führungsabschnitt 16 mit seinem unteren Rand auf die Verriegelungszapfen 14, wodurch das Gehäuseoberteil 1 in Richtung des Bodens 10 von dem Unterteil 2 gezogen wird. Bei dieser Abwärtsbewegung in Richtung des Bodens 10 wird das Gehäuseoberteil 1 zumindest um zwei sich auf den beiden Seitenwänden 9 gegenüberliegenden Führungszapfen 11 geschwenkt.

Alternativ zur vorbeschriebenen Ausführung kann der Verriegelungshebel auch um 180° gedreht montiert sein. Dann ist der Griff 15 zum Gehäuseoberteilende 18 zu führen, damit das Modul aus der Befestigungsausgangsposition nach Fig. 2 in den geschlossenen Zustand nach Fig. 1 überführt wird.

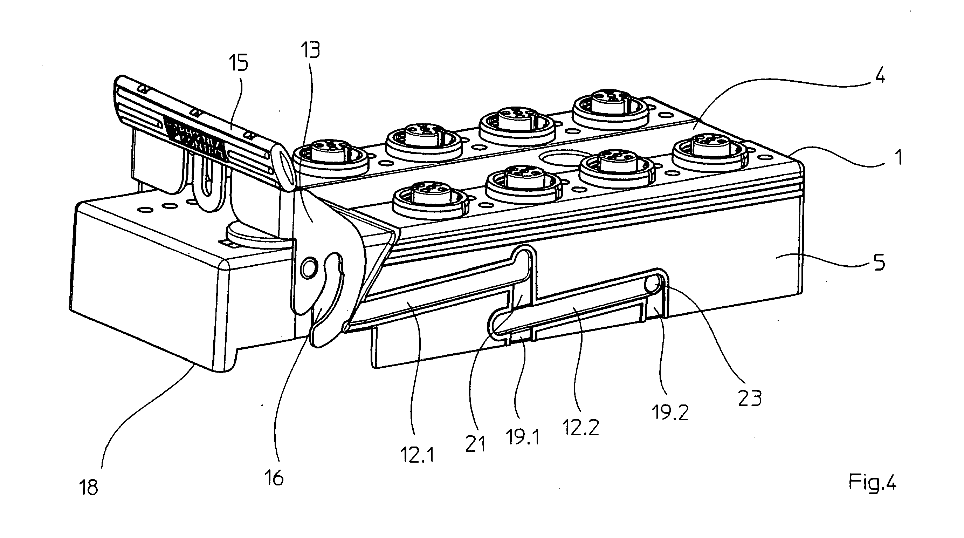

Wie aus Fig. 4 ersichtlich, sind eine obere Führungsnut 12.1 und eine untere Führungsnut 12.2 auf jeder Längsseite 5 des Gehäuseoberteils 1 angeordnet. Die untere Führungsnut 12.2 ist in ihren beiden Endbereichen mit jeweils einer von dem unteren Rand der Längsseite 5 ausgehenden hinteren Einführungsnut 19.2 und einer vorderen Einführungsnut 19.1 verbunden, während eine Verbindungsnut 21 von der unteren Führungsnut 12.2 in die oberen Führungsnut 12.1 mündet.

Die beiden Einführungsnuten 19.1, 19.2 und die beiden auf den Seitenwänden 9 des Unterteils 2 ausgebildeten Führungszapfen 11.1, 11.2 weisen jeweils zueinander in Längsrichtung des Moduls 3 denselben Abstand auf. Der lotrechte Abstand zwischen dem vorderen Führungszapfen 11.1 und dem hinteren Führungszapfen 11.2 bezogen auf den Boden 10 entspricht dem lotrechten Abstand zwischen den beiden Führungsnuten 12.1, 12.2 bezogen auf die Oberseite 4 des Gehäuseoberteils 1.

Durch die vorbeschriebene Abstimmung der räumlichen Anordnung der Führungszapfen 11.1, 11.2 und der Nuten 12.1, 12.2, 19.1, 19.2, 21 wird erreicht, dass das Gehäuseoberteil 1 über seine Einführungsnuten 19.1, 19.2 auf die Führungszapfen 11.1, 11.2 geschoben werden kann, wobei die vorderen Führungszapfen 11.1 über die unteren Einführungsnuten 12.2 und die Verbindungsnuten 21 in die obere Führungsnuten 12.1 geführt werden können. Die hinteren Führungszapfen 11.2 können lediglich in die unteren Führungsnuten 12.2 geführt werden.

Die Nuttiefe der Verbindungsnut 21 und der Einführungsnut 19 ist kleiner als die der Führungsnuten 12, damit die Führungswände der Führungsnuten 12 nicht durchbrochen werden und diese eine sichere Führung des Gehäuseoberteils 1 über die Führungszapfen 11 gewährleisten. Um eine Fixierung des Gehäuseoberteils 1 in der Befestigungsausgangsposition und in der Montageposition sicherzustellen, weisen die Führungsnuten 12 in ihren Verlauf den vorgenannten Positionen entsprechende Verrastungspositionen 23 auf. Die Verrastungspositionen 23 sind als Einprägungen in den Führungsnuten 12 vorgesehen, deren Durchmesser vorzugsweise denen der Führungszapfen 11 entspricht.

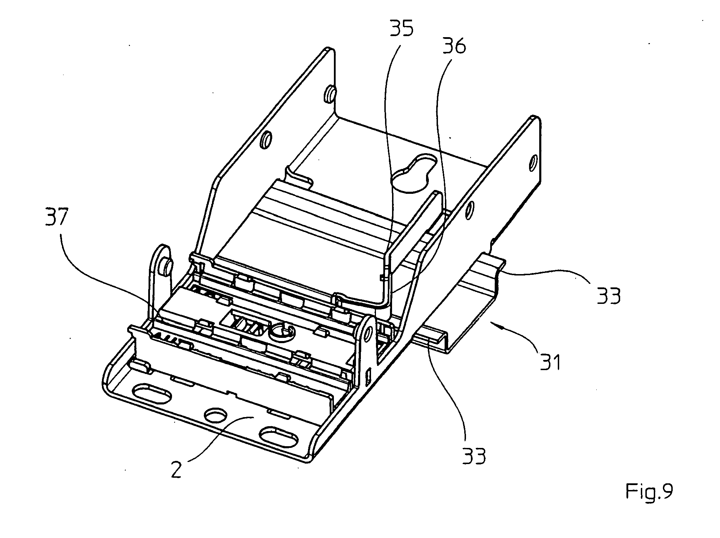

Fig. 6 zeigt das Unterteil 2 für sich ohne das aufgesetzte Gehäuseoberteil 1 und ohne einen als Losteil ausgeführten Aufnahmeeinsatz 25 zur Aufnahme der formcodierten Flachkabel 8. Das Unterteil 2 besteht zumindest zum größten Teil aus leitfähigem Metall. Der Boden 10 umfasst einen ausgesparten Bereich 27, dessen angrenzender Randbereich 29 derart bemessen und ausgeformt ist, dass eine Tragschiene 31 mit ihren Halteabschnitten 33 aufgenommen werden kann (s. Fig. 9). Zur Klemmung der Tragschiene 31 weist das Unterteil 2 eine Feder 35 auf, auf die vorzugsweise eine Überfeder 36 zur Verstärkung ihrer Haltekraft angebracht ist. Sie ist derart an den Boden 10 angebunden und ausgestaltet, dass sie sich in Längsrichtung über den größten Teil des ausgesparten Bereichs 27 erstreckt und eine von dem Unterteil 2 aufgenommene Tragschiene 31 an ihren Halteabschnitten 33 klemmt. Vorzugsweise übergreift die Feder 35 eine aufgenommene Tragschiene 31 in ihrer Querrichtung derart, dass die Kraft der Feder 35 auf den Halteabschnitt 33 der Tragschiene 31 und längs zu dem Unterteils 2 in Richtung der Führungszapfen 11 wirkt.

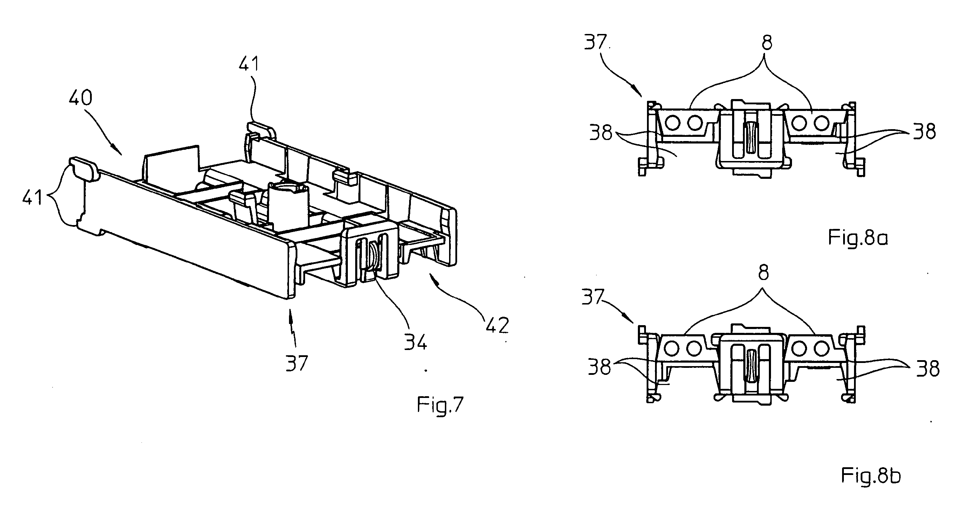

Das Unterteil 2 weist zur Fixierung eines in Fig. 7 dargestellten Aufnahmeeinsatzes 37 mit Ausnehmungen 38 zur Aufnahme der formcodierten Flachkabel 8 Durchbrüche 39 auf. Diese sind zu einer gedachten Symmetrie-Ebene zwischen den beiden Seitenwänden 9 unsymmetrisch angeordnet. Korrespondierend zu den Durchbrüchen 39 umfasst der Aufnahmeeinsatz 37 nur auf einer ersten Schmalseite 40 an seinen vier Ecken Haltenasen 41 sowie ein auf der hierzu gegenüberliegenden zweiten Schmalseite 42 angeordnetes Federelement 43. Die Haltenasen 41 und das Federelement 43 sind derart angeordnet, dass der Aufnahmeeinsatz 37 in zwei zueinander mit 180° um seine Längsachse gedrehte Positionen in das Unterteil 2 eingesetzt werden kann. Aufgrund der oben beschriebenen unsymmetrischen Anordnung der Haltenasen 41, des Federelements 43 und der entsprechenden Durchbrüche 39 kann der Aufnahmeeinsatz 37 nicht in zwei zueinander mit 180° um seine Querachse gedrehte Positionen in das Unterteil 2 eingesetzt werden. Durch die vorbeschriebenen Anordnungen der Haltenasen 41 und des Federelements 43 wird erreicht, dass nur zwei Stellungen zum Einsatz des Aufnahmeeinsatzes 37 existieren und eine Kodierung vorliegt.

In Fig. 8a ist der Aufnahmeeinsatz 37 mit in den Ausnehmungen 38 eingelegten formcodierten Flachkabeln 8 dargestellt, wobei Fig. 8b denselben Aufnahmeeinsatz 37 in derselben Ansicht um 180° gedreht zeigt. Dabei ist der Aufnahmeeinsatz 37 mit seinen Ausnehmungen 38 derart gestaltet, dass die formcodierten Flachkabein 8 in den beiden Positionen nach Fig. 8a u. 8b in den nach oben weisenden Ausnehmungen 38 jeweils nur in eine Lage eingelegt werden können.

Der Aufnahmeeinsatz 37 kann sowohl in dem erfindungsgemäßen Modul 3 mit seinen besonders ausgestalteten Führungsmitteln 11, 12 als auch in aus dem Stand der Technik bekannte Module eingesetzt werden.

Das Unterteil 2 ist mit der Feder 35 nach der vorliegenden Ausführung einstückig ausgebildet. Es besteht aus Blech und ist im Stanz-Biegeverfahren hergestellt worden. Es weist gem. Fig. 6 neben den Durchbrüchen 39 und Montagebohrungen 47 einen Erdungskontakt 49 auf. Dieser ist vorzugsweise tulpenförmig ausgebildet und aus dem Boden 10 herausgebogen.

## Patentansprüche

1. Modul (3) mit Anschlüssen (7) für Aktoren und/oder Sensoren,
welches ein Unterteil (2) mit wenigstens einer Ausnehmung (38) zur Aufnahme eines formcodierten Flachkabels (8) und
ein auf das Unterteil (2) über Befestigungsmittel (13, 14) montierbares Gehäuseoberteil (1) zur Aufnahme einer Leiterplatte aufweist,
welches umfangseitig wenigstens zwei Längsseiten (5) und zwei Stirnseiten (6) aufweist und
über an dem Gehäuseoberteil (1) und/oder dem Unterteil (2) angeordneten Führungsmittel (11, 12) in eine Befestigungsausgangsposition zu seiner Befestigung auf dem Unterteil (2) führbar ist, wobei das Gehäuseoberteil (1) und/oder Unterteil (2) eine Kontakteinrichtung mit Kontaktstiften umfasst, welche bei der Befestigung des Gehäuseoberteils
(1) auf dem Unterteil (2) ein in der Ausnehmung (38) aufgenommenes formcodiertes Flachkabel (8) zumindest teilweise durchdringen und deren Leiter (8.1) kontaktieren,
**dadurch gekennzeichnet,**
**dass** das Gehäuseoberteil (1) über seine Längsseiten (5) mit den Führungsmitteln (11, 12) zusammenwirkt und in die Befestigungsausgangsposition führbar ist.

2. Modul (3) mit Anschlüssen (7) für Aktoren und/oder Sensoren nach Anspruch 1,
**dadurch gekennzeichnet,**
**dass** das Unterteil (2) einen Boden (10) und zwei wenigstens in Teilbereichen als Führungsmittel (11, 12) ausgebildete einander gegenüber angeordnete Seitenwände (9) umfasst.

3. Modul mit Anschlüssen (7) für Aktoren und/oder Sensoren nach Anspruch 2,
**dadurch gekennzeichnet,**
**dass** das Unterteil (2) mit seinem Boden (10) und den beiden Seitenwänden (9) eine stirnseitig offene Aufnahmekammer bildet.

4. Modul (3) mit Anschlüssen (7) für Aktoren und/oder Sensoren nach mindestens einem der vorstehenden Ansprüche,
**dadurch gekennzeichnet,**
**dass** die Führungsmittel (11, 12) derart konfiguriert sind, dass sie zur umfangseitigen Klemmung des Gehäuseoberteils (1) geeignet sind.

5. Modul (3) mit Anschlüssen (7) für Aktoren und/oder Sensoren nach mindestens einem der vorstehenden Ansprüche,
**dadurch gekennzeichnet,**
**dass** die Führungsmittel (11, 12) derart an dem Gehäuseoberteil (1) und/oder dem Unterteil (2) ausgebildet sind, dass das Gehäuseoberteil (1) über eine Transversalbewegung führbar ist.

6. Modul (3) mit Anschlüssen (7) für Aktoren und/oder Sensoren nach mindestens einem der vorstehenden Ansprüche 2 bis 5,
**dadurch gekennzeichnet,**
**dass** als Führungsmittel (11, 12) auf den beiden Längsseiten (5) des Gehäuseoberteils
(1) jeweils wenigstens ein Führungszapfen (11) vorgesehen ist, wobei auf den beiden Seitenwänden (9) des Unterteils jeweils wenigstens eine Führungsnut (12) zur Führung des Gehäuseoberteils (1) über die Führungszapfen (11) angeordnet ist.

7. Modul (3) mit Anschlüssen (7) für Aktoren und/oder Sensoren nach mindestens einem der vorstehenden Ansprüche 2 bis 5,
**dadurch gekennzeichnet,**
**dass** als Führungsmittel (11, 12) auf den beiden Seitenwänden (9) des Unterteils (2) jeweils wenigstens ein zu der gegenüberliegenden Seitenwand (9) weisender Führungszapfen (11) angeordnet ist, wobei zur Führung des Gehäuseoberteils (1) über die Führungszapfen (11) auf seinen beiden Längsseiten (5) jeweils wenigstens eine Führungsnut (12) vorgesehen ist.

8. Modul (3) mit Anschlüssen (7) für Aktoren und/oder Sensoren nach Anspruch 7,
**dadurch gekennzeichnet,**
**dass** auf den beiden Längsseiten (5) des Gehäuseoberteils (1) jeweils eine zu der Führungsnut (12) führende und von dem Rand der jeweiligen Längseite (5) ausgehende Einführungsnut (19) vorgesehen ist.

9. Modul (3) mit Anschlüssen (7) für Aktoren und/oder Sensoren nach Anspruch 8,
**dadurch gekennzeichnet,**
**dass** die Nuttiefe der Einführungsnut (19) kleiner als die der Führungsnut (12) ist.

10. Modul (3) mit Anschlüssen (7) für Aktoren und/oder Sensoren nach Anspruch 9,
bei dem das Gehäuseoberteil eine Unterseite und eine hierzu gegenüberliegende Oberseite (4) mit den Anschlüssen (7) für die Aktoren und/oder Sensoren aufweist,
**dadurch gekennzeichnet,**
**dass** die Führungsnut (12) schräg zu der Unterseite und/oder Oberseite (4) verläuft.

11. Modul (3) mit Anschlüssen (7) für Aktoren und/oder Sensoren nach mindestens einem der vorstehenden Ansprüche 2 bis 10,
**dadurch gekennzeichnet,**
**dass** auf den beiden Längsseiten (5) des Gehäuseoberteils (1) wenigstens jeweils zwei zueinander parallel angeordnete Führungsnuten (12.1, 12.2) vorgesehen sind,
wobei auf den beiden Seitenwänden (9) des Unterteils (2) jeweils wenigstens zwei den Führungsnuten (12.1, 12.2) zugeordnete Führungszapfen (11.1, 11.2) ausgebildet sind.

12. Modul (3) mit Anschlüssen (7) für Aktoren und/oder Sensoren nach Anspruch 11,
**dadurch gekennzeichnet,**
**dass** die beiden parallel zueinander angeordneten Führungsnuten (12.1, 12.2) durch eine Verbindungsnut (21) miteinander verbunden sind.

13. Modul (3) mit Anschlüssen (7) für Aktoren und/oder Sensoren nach Anspruch 12
**dadurch gekennzeichnet,**
**dass** die Verbindungsnut (21) im Wesentlichen senkrecht zu der Unterseite und/oder Oberseite (4) des Gehäuseoberteils (1) verläuft.

14. Modul (3) mit Anschlüssen (7) für Aktoren und/oder Sensoren nach Anspruch 12 oder 13,
**dadurch gekennzeichnet,**
**dass** die Nuttiefe der Verbindungsnut (21) kleiner ist als die der Führungsnuten (12.1, 12.2).

15. Modul (3) mit Anschlüssen (7) für Aktoren und/oder Sensoren nach mindestens einem der vorstehenden Ansprüche 6 bis 14,
**dadurch gekennzeichnet,**
**dass** die Führungsnut (12) wenigstens eine Verrastungsposition (23) zum Einrasten des in ihr geführten Führungszapfen (11) aufweist.

## Claims

1. A module (3) with connections (7) for actuators and/or sensors,
comprising a lower part (2) with at least one recess (38) for receiving a form-coded flat cable (8) and a housing upper part (1) mountable on top of the lower part (2) via fastening means (13, 14) for receiving a printed circuit board,
which on its circumference comprises at least two longitudinal sides (5) and two faces (6) and
which can be guided, via guiding means (11, 12) arranged on the housing upper part (1) and/or the lower part (2), into an initial mounting position for mounting it on top of the lower part (2), whereby the housing upper part (1) and/or lower part (2) comprises a contacting device with contact pins which, which when the housing upper part (1) is mounted on top of the lower part (2), penetrate at least partially a form-coded flat cable (8) received in the recess (38) and make contact with its conductors (8.1),
**characterised in that**
the housing upper part (1) cooperates with the guiding means (11, 12) via its longitudinal sides (5) and can be guided into the initial mounting position.

2. Module (3) with connections (7) for actuators and/or sensors according to claim 1,
**characterised in that**
the lower part (2) comprises a bottom (10) and two side walls (9) formed, at least in some areas, as guiding means (11, 12) and arranged opposite one another.

3. Module with connections (7) for actuators and/or sensors according to claim 2,
**characterised in that**
the lower part (2) with its bottom (10) and two side walls (9) forms a receiving chamber open on the face.

4. Module with connections (7) for actuators and/or sensors according to at least one of the above claims,
**characterised in that**
the guiding means (11, 12) are configured such that they are suitable for circumferential clamping of the housing upper part (1).

5. Module with connections (7) for actuators and/or sensors according to at least one of the above claims,
**characterised in that**
the guiding means (11, 12) are formed on the housing upper part (1) and/or the lower part (2) in such a way that the housing upper part (2) can be guided via a transverse movement.

6. Module with connections (7) for actuators and/or sensors according to at least one of claims 2 to 5 above,
**characterised in that**
at least one guiding pin (11), respectively, is provided as guiding means (11, 12) on the two longitudinal sides (5) of the housing upper part (1), whereby at least one guiding groove (12), respectively, is arranged on the two side walls (9) of the lower part for guiding the housing upper part (1) via the guiding pins (11).

7. Module with connections (7) for actuators and/or sensors according to at least one of claims 2 to 5 above,
**characterised in that**
at least one guiding pin (11), respectively, is provided as guiding means (11, 12) on the two side walls (9) of the lower part (2), which pin points to the opposite side wall (9), whereby at least one guiding groove (12), respectively, is provided on the two longitudinal sides (5) of the housing upper part (1) for guiding the housing upper part via the guiding pins (11).

8. Module (3) with connections (7) for actuators and/or sensors according to claim 7,
**characterised in that**
an entry groove (19), respectively, is provided on the two longitudinal sides (5) of the housing upper part (1), which leads to the guiding groove (12) and starts from the edge of the respective longitudinal side (5).

9. Module (3) with connections (7) for actuators and/or sensors according to claim 8,
**characterised in that**
the depth of the entry groove (19) is less than that of the guiding groove (12).

10. Module (3) with connections (7) for actuators and/or sensors according to claim 9, on which the housing upper part comprises an underside and an upper side (4) opposite to the underside with connections (7) for the actuators and/or sensors,
**characterised in that**
the guiding groove (12) extends obliquely to the underside and/or upper side (4).

11. Module with connections (7) for actuators and/or sensors according to at least one of claims 2 to 10 above,
**characterised in that**
at least two guiding grooves (12.1, 12.2), respectively, extending in parallel to each other are arranged on the two longitudinal sides (5) of the housing upper part (1), whereby at least two guiding pins (11.1, 11.2), respectively, associated with the guiding grooves (12.1, 12.2) are formed on the two side walls (9) of the lower part (2).

12. Module (3) with connections (7) for actuators and/or sensors according to claim 11,
**characterised in that**
the two guiding grooves (12.1, 12.2) extending in parallel to each other are connected with each other via a connecting groove (21).

13. Module (3) with connections (7) for actuators and/or sensors according to claim 12,
**characterised in that**
the connecting groove (21) extends substantially perpendicularly to the underside and/or the upper side (4) of the housing upper part (1).

14. Module (3) with connections (7) for actuators and/or sensors according to claim 12 or 13,
**characterised in that**
the depth of the connecting groove (21) is less than that of the guiding grooves (12.1, 12.2).

15. Module with connections (7) for actuators and/or sensors according to at least one of claims 6 to 14 above,
**characterised in that**
the guiding groove (12) comprises at least one detent position (23) for retaining the guiding pin (11) guided in it.

## Revendications

1. Module (3) comprenant des branchements (7) pour des actionneurs et/ou des capteurs,
qui présente une partie inférieure (2) avec au moins une cavité (38) pour le logement d'un câble plat (8) codé au niveau de la forme et
une partie supérieure de boîtier (1) qui peut être montée sur la partie inférieure (2) à l'aide de moyens de fixation (13, 14) pour le logement d'une carte à circuits imprimés,
laquelle présente côté périphérie au moins deux côtés longitudinaux (5) et deux côtés avant (6) et
peut être guidée à l'aide de moyens de guidage (11, 12) disposés sur la partie supérieure de boîtier (1) et/ou la partie inférieure (2) dans une position de départ de fixation pour sa fixation sur la partie inférieure (2), la partie supérieure de boîtier (1) et/ou la partie inférieure (2) comprenant un dispositif de contact avec des broches de contact, lesquelles traversent au moins en partie un câble plat (8) codé au niveau de la forme et logé dans l'évidement (38) lors de la fixation de la partie supérieure de boîtier (1) sur la partie inférieure (2) et établissent un contact avec leurs conducteurs (8.1)
**caractérisé en ce que**
la partie supérieure de boîtier (1) coopère par ses côtés longitudinaux (5) avec les moyens de guidage (11, 12) et peut être guidée dans la position de départ de fixation.

2. Module (3) comprenant des branchements (7) pour des actionneurs et/ou des capteurs selon la revendication 1,
**caractérisé en ce que**
la partie inférieure (2) comprend un fond (10) et deux parois latérales (9) conçues au moins dans des zones partielles comme moyens de guidage (11, 12) et disposées face-à-face.

3. Module comprenant des branchements (7) pour des actionneurs et/ou des capteurs selon la revendication 2,
**caractérisé en ce que**
la partie inférieure (2) forme une chambre de logement ouverte côté avant avec son fond (10) et les deux parois latérales (9).

4. Module (3) comprenant des branchements (7) pour des actionneurs et/ou des capteurs selon au moins l'une quelconque des revendications précédentes,
**caractérisé en ce que**
les moyens de guidage (11, 12) sont configurés de telle sorte qu'ils sont appropriés pour le blocage côté périphérie de la partie supérieure de boîtier (1).

5. Module (3) comprenant des branchements (7) pour des actionneurs et/ou des capteurs selon au moins l'une quelconque des revendications précédentes,
**caractérisé en ce que**
les moyens de guidage (11, 12) sont réalisés sur la partie supérieure de boîtier (1) et/ou la partie inférieure (2) de telle sorte que la partie supérieure de boîtier (1) peut être guidée au moyen d'un mouvement transversal.

6. Module (3) comprenant des branchements (7) pour des actionneurs et/ou des capteurs selon au moins l'une quelconque des revendications 2 à 5 précédentes,
**caractérisé en ce que**
il est prévu à chaque fois au moins un tenon de guidage (11) comme moyen de guidage (11, 12) sur les deux côtés longitudinaux (5) de la partie supérieure de boîtier (1), à chaque fois au moins une rainure de guidage (12) étant disposée sur les deux parois latérales (9) de la partie inférieure pour le guidage de la partie supérieure de boîtier (1) au moyen des tenons de guidage (11).

7. Module (3) comprenant des branchements (7) pour des actionneurs et/ou des capteurs selon au moins l'une quelconque des revendications 2 à 5 précédentes,
**caractérisé en ce que**
à chaque fois au moins un tenon de guidage (11) dirigé vers la paroi latérale (9) opposée est disposé comme moyen de guidage (11, 12) sur les deux parois latérales (9) de la partie inférieure (2), à chaque fois au moins une rainure de guidage (12) étant prévue pour le guidage de la partie supérieure de boîtier (1) au moyen des tenons de guidage (11) sur ses deux côtés longitudinaux (5).

8. Module (3) comprenant des branchements (7) pour des actionneurs et/ou des capteurs selon la revendication 7,
**caractérisé en ce que**
à chaque fois une rainure d'introduction (19) aboutissant à la rainure de guidage (12) et partant du bord du côté longitudinal (5) respectif est prévue sur les deux côtés longitudinaux (5) de la partie supérieure de boîtier (1).

9. Module (3) comprenant des branchements (7) pour des actionneurs et/ou des capteurs selon la revendication 8,
**caractérisé en ce que**
la profondeur de la rainure d'introduction (19) est inférieure à celle de la rainure de guidage (12).

10. Module (3) comprenant des branchements (7) pour des actionneurs et/ou des capteurs selon la revendication 9,
sur lequel la partie supérieure de boîtier présente un côté inférieur et un côté supérieur (4) opposé au premier côté avec les branchements (7) pour les actionneurs et/ou les capteurs,
**caractérisé en ce que**
la rainure de guidage (12) est agencée en biais par rapport au côté inférieur et/ou au côté supérieur (4).

11. Module (3) comprenant des branchements (7) pour des actionneurs et/ou des capteurs selon au moins l'une quelconque des revendications 2 à 10 précédentes,
**caractérisé en ce que**
à chaque fois au moins deux rainures de guidage (12.1, 12.2) disposées parallèlement entre elles sont prévues sur les deux côtés longitudinaux (5) de la partie supérieure de boîtier (1),
à chaque fois au moins deux des tenons de guidage (11.1, 11.2) associés aux rainures de guidage (12.1, 12.2) étant réalisés sur les deux parois latérales (9) de la partie inférieure (2).

12. Module (3) comprenant des branchements (7) pour des actionneurs et/ou des capteurs selon la revendication 11,
**caractérisé en ce que**
les deux rainures de guidage (12.1, 12.2) disposées parallèlement entre elles sont reliées entre elles par une rainure de liaison (21).

13. Module (3) comprenant des branchements (7) pour des actionneurs et/ou des capteurs selon la revendication 12,
**caractérisé en ce que**
la rainure de liaison (21) est agencée sensiblement perpendiculairement au côté inférieur et/ou côté supérieur (4) de la partie supérieure de boîtier (1).

14. Module (3) comprenant des branchements (7) pour des actionneurs et/ou des capteurs selon la revendication 12 ou 13,
**caractérisé en ce que**
la profondeur de rainure de la rainure de liaison (21) est inférieure à celle des rainures de guidage (12.1, 12.2).

15. Module (3) comprenant des branchements (7) pour des actionneurs et/ou des capteurs selon au moins l'une quelconque des revendications 6 à 14 précédentes,
**caractérisé en ce que**
la rainure de guidage (12) présente au moins une position d'enclenchement (23) pour l'encliquetage du tenon de guidage (11) guidé dans celle-ci.
